Europäisches Patentamt

**European Patent Office**

Office européen des brevets

(19)

(11) Veröffentlichungsnummer: **0 053 711**
**B1**

(12) **EUROPÄISCHE PATENTSCHRIFT**

(45) Veröffentlichungstag der Patentschrift:
**22.05.85**

(51) Int. Cl.⁴: **H 01 L 21/306**

(21) Anmeldenummer: **81109137.0**

(22) Anmeldetag: **28.10.81**

(54) **Verfahren zum Herstellen von Strukturen von aus Siliziden oder aus Silizid-Polysilizium bestehenden Schichten durch reaktives Sputterätzen.**

(30) Priorität: **05.12.80 DE 3045922**

(43) Veröffentlichungstag der Anmeldung:
**16.06.82 Patentblatt 82/24**

(45) Bekanntmachung des Hinweises auf die Patenterteilung:
**22.05.85 Patentblatt 85/21**

(84) Benannte Vertragsstaaten:
**FR GB**

(56) Entgegenhaltungen:
**EP - A - 0 015 403**
**DE - A - 2 111 732**
**DE - B - 2 658 448**
**US - A - 4 213 818**

(73) Patentinhaber: **Siemens Aktiengesellschaft, Berlin und München Wittelsbacherplatz 2, D-8000 München 2 (DE)**

(72) Erfinder: **Beinvogl, Willy, Dr. rer. nat., Tutzinger Strasse 3, D-8000 München 70 (DE)**

ACTORUM AG

## Beschreibung

Die vorliegende Patentanmeldung betrifft ein Verfahren zum Herstellen von Strukturen von aus Siliziden bestehenden Schichten oder aus Silizid-Polysilizium bestehenden Doppelschichten auf integrierte Halbleiterschaltungen enthaltenden Substraten durch reaktives Sputterätzen (Ionenätzen) mit Schwefelhexafluorid ($SF_6$) als Ätzgas unter Verwendung einer Fotolackätzmaske.

Zur Herstellung hochintegrierter MOS-Schaltungen werden in der Ätztechnik anisotrope Ätzverfahren eingesetzt, um eine masshaltige Strukturübertragung zu gewährleisten. Ein solches anisotropes Ätzverfahren ist aus dem Chemical Abstracts, Vol. 85, 1976, p. 562, linke Spalte, bekannt. Dabei werden Strukturen in polykristallinen Siliziumschichten in der Grössenrodnung von 10 µm durch reaktives Sputterätzen mit einer Mischung aus gasförmigen Sauerstoff und Tetrafluorkohlenstoff ($CF_4$ = Freon®) untersucht, wobei als Ätzmasken Filme aus fotoempfindlichen Lacken verwendet werden. Das Ätzprofil der in den polykristallinen Siliziumschichten erzeugten Strukturen ist dabei weitgehend abhängig von der Dicke der Siliziumschicht sowie von der eingespeisten Hochfrequenzleistung.

Um den ohm'schen Widerstand von Polysiliziumbahnen bei der Herstellung von integrierten Schaltungen in der MOS-Technologie zu vermindern, werden die Polysiliziumbahnen durch Metallsilize ersetzt oder auf die Polysiliziumbahnen eine zusätzliche Metallsilizidschicht (= «Polyzid»-Schicht) aufgebracht. Um hier eine Strukturerzeugung von Strukturen im Bereich von 1 µm durchzuführen, müssen anisotrope Ätzverfahren angewandt werden. Ein anisotropes Ätzverfahren für ein Silizid, bei dem $CF_4$ als Ätzgas verwendet wird, ist aus den Transactions on Electron Devices, Vol. ED-26, No. 4, April 1979, aus einem Aufsatz von Crowder und Zirinsky auf den Seiten 369 bis 371 zu entnehmen. Das hier beschriebene Verfahren ist streng anisotrop; Fotolack kann aber wegen der schlechten Selektivität zum Silizid als Ätzmaske nicht verwendet werden. Andere Masken, z.B. aus Aluminium, sind möglich, komplizieren aber den Prozessablauf. Ein weiterer Nachteil ist, dass die Selektivität von Polysilizium zu $SiO_2$ nur etwa 2:1 beträgt.

Eine weitere Selektivität von Polysilizium zu $SiO_2$ und $Si_3N_4$ wird erhalten, wenn man beim Ätzen von Silizium eine Gasmischung aus Schwefelhexafluorid ($SF_6$), Chlor und Inertgas verwendet (siehe europäische Patentanmeldung 0 015 403).

Der Erfindung liegt die Aufgabe zugrunde, einen reproduzierbaren Ätzprozess für die Herstellung von Strukturen von aus Metallsiliziden bestehenden Schichten oder aus Metallsilizid-Polysilizium bestehenden Doppelschichten mit Strukturbreiten bis zu 1 µm anzugeben, wobei

a) eine strenge Anisotropie, das heisst, keine Unterätzung stattfindet,

b) eine gute Selektivität zu den darunterliegenden Schichten ($SiO_2$) gewährleistet ist,

c) die Verwendbarkeit von Fotolack als Ätzmaske möglich ist,

d) möglichst hohe Ätzraten, das heisst, kurze Ätzzeiten einstellbar sind und

e) der Ätzangriff möglichst gleichmässig erfolgt.

Diese Aufgabe wird durch ein Verfahren der eingangs genannten Art dadurch gelöst, dass erfindungsgemäss der Ätzprozess in zwei Schritten durchgeführt wird, wobei zunächst mit einer HF-Leistung von grösser als 0,3 W/cm² mit hoher Ätzrate und anschliessend mit einer HF-Leistung von weniger als 0,2 W/cm² mit geringerer Ätzrate geätzt wird. Der erste Verfahrensschritt erzielt eine strenge Anisotropie, der zweite Verfahrensschritt eine gute Selektivität zu $SiO_2$.

Es liegt im Rahmen der Erfindung, den ersten Ätzprozess bei 0,3 bis 0,5 W/cm² und den zweiten Ätzprozess bei 0,1 W/cm² durchzuführen.

In einer Weiterbildung des Erfindungsgedankens ist vorgesehen, aus Gründen der Plasmastabilität das Ätzgas ($SF_6$) mit Helium zu verdünnen, wobei vorzugsweise eine Verdünnung im Verhältnis $SF_6$:He = 1:5 (Volumenanteile) eingestellt wird.

Da der Ätzangriff auf jeder Siliziumkristallscheibe vom Rand her erfolgt, werden gemäss einem Ausführungsbeispiel nach der Lehre der Erfindung zur Vergleichmässigung des Ätzangriffes die Siliziumsubstrate mit Metallringen, vorzugsweise aus Aluminium bestehend, umlegt. Diese verändern den Gasfluss im Plasma-Reaktor derart, dass die Gleichmässigkeit um 30 bis 40% verbessert wird. Dabei muss die Höhe der Ringe richtig gewählt werden. Im Ausführungsbeispiel sind 4 mm optimal. Um Kontamination der Scheiben zu vermeiden, ist es von Vorteil, für die Ringe Reinstaluminium zu verwenden.

Besonders geeignet ist das erfindungsgemässe Verfahren für die Herstellung von aus Wolfram-, Molybdän- und Tantalsilizid bestehenden Strukturen. Mit Hexaflurid ($SF_6$) können Silizide beliebigen Metallgehalts geätzt werden. Die Ätzrate sinkt mit steigendem Metallgehalt.

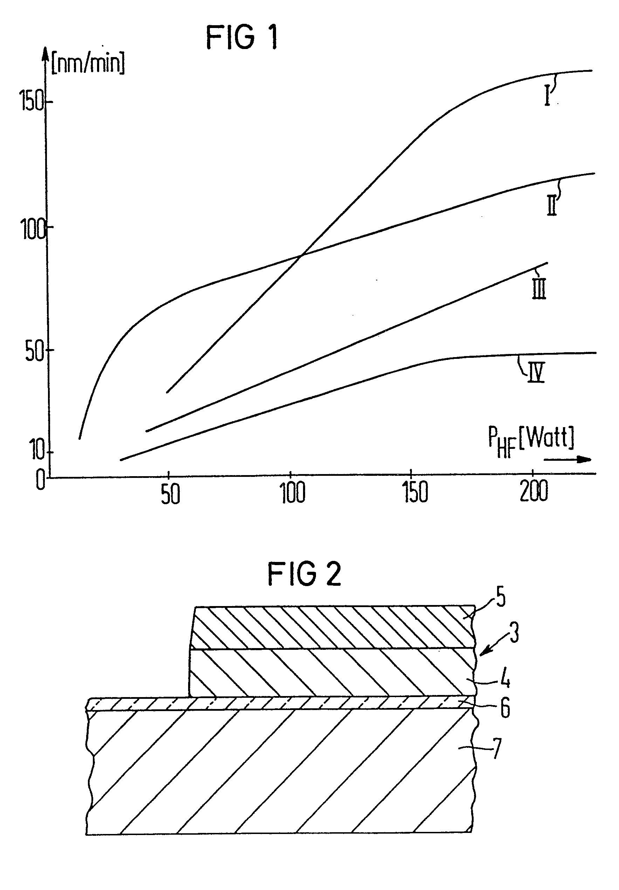

Weitere Einzelheiten sowie Vorteile des erfindungsgemässen Verfahrens werden im folgenden anhand eines Ausführungsbeispiels und der Fig. 1 und 2 noch näher erläutert. Dabei zeigt

die Fig. 1 die Abhängigkeit der Ätzraten in nm/min von Fotolack, Polysilizium, Molybdänsilizid und $SiO_2$ als Funktion der HF-Leistung ($P_{HF}$) in Watt,

die Fig. 2 im Schnittbild eine aus einer Doppelschicht Polysilizium/Molybdänsilizid bestehende geätzte Struktur (aus Zeichnung einer Rasterelektronenmikroskopaufnahme in 16 000facher Vergrösserung).

Die Fig. 1 zeigt die Abhängigkeit der Ätzrate von Fotolack (Kurve I), Polysilizium (Kurve II), Molybdänsilizid (Kurve III) und $SiO_2$ (Kurve IV) unter Verwendung von mit Helium verdünntem $SF_6$-Gasgemisch (Verhältnis $SF_6$:He = 1:5) von der HF-Leistung. Wie aus dem Kurvendiagramm zu entnehmen ist, hat Polysilizium (Kurve II) bei kleinen HF-Leistungen bereits eine hohe Ätzrate; sie ist im Vergleich zu Molybdänsilizid (Kurve III) etwa dreimal so hoch. Die Selektivität Polysilizium (Kurve II) zu $SiO_2$ (Kurve IV) ist grösser als 10:1 in der zweiten Stufe. Fotolack (AZ 1450 I der Firma Shipley) kann als Ätzmaske verwendet werden. Der Lackabtrag liegt im Bereich der Dikke der geätzten Doppelschicht (ca. 500 nm).

Fig. 2 zeigt am Beispiel einer Doppelschicht 3 aus 300 nm dicken dotierten Polysilizium 4 und einer darüberliegenden 200 nm dicken Molybdänsilizidschicht 5 mit einem Anteil an Molybdän von 35%, dass ein streng anisotroper Ätzprozess stattgefunden hat. Es findet keine Unterätzung der Polysiliziumschicht 4 unter der Molybdänsilizidschicht 5 statt, obwohl die Ätzrate des Polysiliziums 4 etwa dreimal höher ist als die des Molybdänsilizids 5. Die Selektivität der Polysiliziumschicht 4 gegenüber der darunterliegenden $SiO_2$-Schicht 6 ist sehr gross. Mit dem Bezugszeichen 7 ist das Halbleitersubstrat aus Silizium bezeichnet. Die Lackmaske ist bereits entfernt. Die Ätzzeit für die aus Polysilizium 4 und Molybdänsilizid 5 bestehenden Doppelschicht 3 beträgt beim erfindungsgemässen Verfahren etwa 12 Minuten; bei bekannten Verfahren (z.B. Ätzen im $CF_4$-Plasma) ist die Ätzzeit mehr als doppelt so lang.

**Patentansprüche**

1. Verfahren zum Herstellen von Strukturen von aus Siliziden bestehenden Schichten oder aus Silizid-Polysilizium bestehenden Doppelschichten auf integrierte Halbleiterschaltungen enthaltenden Substraten durch reaktives Sputterätzen (Ionenätzen) mit Schwefelhexafluorid ($SF_6$) als Ätzgas unter Verwendung einer Fotolackmaske, dadurch gekenzeichnet, dass der Ätzprozess in zwei Schritten durchgeführt wird, wobei zunächst mit einer HF-Leistung von grösser als 0,3 W/cm² mit hoher Ätzrate und anschliessend mit einer HF-Leistung von weniger als 0,2 W/cm² mit geringerer Ätzrate geätzt wird.

2. Verfahren nach Anspruch 1, dadurch gekennzeichnet, dass der erste Ätzschritt bei 0,3 bis 0,5 W/cm² durchgeführt wird.

3. Verfahren nach Anspruch 1 und/oder 2, dadurch gekennzeichnet, dass der zweite Ätzschritt bei 0,1 W/cm² durchgeführt wird.

4. Verfahren nach Anspruch 1 bis 3, dadurch gekennzeichnet, dass das Ätzgas mit Helium verdünnt wird.

5. Verfahren nach Anspruch 4, dadurch gekennzeichnet, dass die Verdünnung im Verhältnis $SF_6$:He = 1:5 (Volumenanteile) erfolgt.

6. Verfahren nach Anspruch 1 bis 5, dadurch gekennzeichnet, dass während des Sputterätzens zur Vergleichmässigung des Ätzangriffes die Substrate mit Metallrahmen, insbesondere Aluminiumringen, umgeben werden.

7. Verwendung des Verfahrens nach Anspruch 1 bis 6 zur Herstellung von Strukturen aus Wolfram-, Molybdän- und Tantalsiliziden.

**Claims**

1. A method for the production of structures from layers consisting of silicides, or double layers consisting of silicide-polysilicon, on substrates containing integrated semiconductor circuits by reactive sputter etching (ion etching) with sulphur hexafluoride ($SF_6$) as etching gas using a photolacquer mask, characterised in that the etching process is carried out in two steps, in which etching is first carried out with an HF-power which is greater than 0.3 W/cm² at a high etching rate, and is subsequently carried out with an HF-power which is less than 0.2 W/cm² at a lower etching rate.

2. A method as claimed in Claim 1, characterised in that the first etching step is carried out at 0.3 to 0.5 W/cm².

3. A method as claimed in Claim 1 and/or Claim 2, characterised in that the second etching step is carried out at 0.1 W/cm².

4. A method as claimed in Claim 1 to 3, characterised in that the etching gas is diluted with helium.

5. A method as claimed in Claim 4, characterised in that the dilution is effected in a ratio of $SF_6$:He = 1:5 (parts by volume).

6. A method as claimed in Claim 1 to 5, characterised in that during the sputter etching, in order to homogenize the etching attack, the substrates are surrounded by metal frames, in particular aluminium rings.

7. The use of the method claimed in Claim 1 to 6 for the production of structures from tungsten, molybdenum and tantalum silicides.

**Revendications**

1. Procédé de fabrication de structures de couches en siliciures ou de couches doubles en siliciure-polysilicium sur des substrats contenant des circuits intégrés à semi-conducteurs par gravure réactive par pulvérisation cathodique (gravure ionique) avec de l'hexafluorure de soufre ($SF_6$) comme gaz de gravure en utilisant un masque en vernis photosensible, caractérisé en ce qu'il consiste à effectuer le procédé de gravure en deux stades en gravant d'abord avec une puissance en haute fréquence, supérieure à 0,3 W/cm², avec une grande vitesse de gravure et ensuite avec une puissance en haute fréquence, inférieure à 0,2 W/cm², avec une faible vitesse de gravure.

2. Procédé suivant la revendication 1, caractérisé en ce qu'il consiste à effectuer le premier stade de gravure entre 0,3 W/cm² et 0,5 W/cm².

3. Procédé suivant la revendication 1 et/ou 2, caractérisé en ce qu'il consiste à effectuer le second stade de gravure à 0,1 W/cm².

4. Procédé suivant les revendications 1 à 3, caractérisé en ce qu'il consiste à diluer le gaz de gravure par de l'hélium.

5. Procédé suivant la revendication 4, caractérisé en ce qu'il consiste à effectuer la dilution

dans le rapport $SF_6:He = 1:5$ (proportions en volume).

6. Procédé suivant les revendications 1 à 5, caractérisé en ce qu'il consiste à entourer les substrats de cadres métalliques, notamment de bagues d'aluminium, pendant la gravure par pulvérisation cathodique, pour uniformiser l'attaque par gravure.

7. Utilisation du procédé suivant les revendications 1 à 6, pour la fabrication de structures en siliciure de tungstène, en siliciure de molybdène et en siliciure de tantale.

# FIG 1

# FIG 2